# EUROPÄISCHE PATENTSCHRIFT

(11) **EP 0 359 937 B1**
(45) Veröffentlichungstag und Bekanntmachung des Hinweises auf die Patenterteilung: **09.02.1994**
(21) Anmeldenummer: 89113409.0
(22) Anmeldetag: 21.07.1989
(51) Int. Cl.: H01P 5/00, G01R 1/04

(54) **Anordnung zur Schaffung eines Messsignalzugangs zu einer Hohlleiteranordnung**
Apparatus for gaining measuring signal access to a hollow conductor
Dispositif d'accès d'un signal de mesure à un conducteur creux

(30) Priorität: 22.09.1988 DE 3832187
(43) Veröffentlichungstag der Anmeldung: 28.03.1990
(73) Patentinhaber: ANT Nachrichtentechnik GmbH, D-71522 Backnang (DE)
(72) Erfinder: Mörz, Günter, Dr.-Ing., D-7140 Ludwigsburg (DE); Beis, Konstantin, Dipl.-Ing., D-7150 Backnang (DE); Junger, Klaus, D-7151 Allmersbach i.Tal (DE)

(56) Entgegenhaltungen:
- DE-C- 835 774
- IEEE TRANSACTIONS ON NUCLEAR SCIENCE, Band NS-30, Nr. 4, Teil 2, August 1983, Seiten 3642-3644; G.A. LOEW et al.: "Microwave measurements of azimuthal asymmetries in accelerating fields of disk-loaded waveguides"
- TECHNISCHES MESSEN, Band 47, Nr. 10, Oktober 1980, Seiten 377-384; U. STUMPER: "Mehrtoranordnungen in der Mikrowellen-Impedanzmesstechnik"
- PATENT ABSTRACTS OF JAPAN, Band 2, Nr. 156 (E-078), 26. Dezember 1978;& JP-A-53 126 809

## Beschreibung

Die vorliegende Erfindung betrifft eine Anordnung zur Schaffung eines oder auch mehrerer Zugänge zu einer Hohlleiteranordnung, um in diese Meßsignale einkoppeln und/oder aus ihr auskoppeln zu können.

Um die elektrischen bzw. magnetischen Eigenschaften einer Hohlleiteranordnung - das kann ein einzelner Hohlleiter, ein Hohlleiterbauelement (z.B. Filter, Mischer, Koppler, Zirkulator etc.) oder auch eine komplexe integrierte Hohlleiterschaltung sein - zu ermitteln, sind entsprechende Messungen vorzunehmen. Dazu sind in die Hohlleiteranordnung zunächst Meßsignale einzukoppeln und am Ende des jeweils der Messung zu unterziehenden Abschnitts der Hohlleiteranordnung wieder auszukoppeln, um sie dann einer Meßvorrichtung zuzuführen. Eine solche Anordnung ist aus der IEEE TRANSACTIONS ON NUCLEAR SCIENCE, Band NS-30, Nr. 4, Teil 2, August 1983, Seiten 3642-3644; G.A. LOEW et al.: "Microwave measurements of azimuthal asymmetries in accelerating fields of disk-loaded waveguides" bekannt.

Bei Reflexionsmessungen erfolgt die Ein- und die Auskopplung am gleichen Meßzugang.

Es ist nun die Aufgabe der Erfindung, eine Anordnung anzugeben, die mit geringem Aufwand an technischen Mitteln und Zeit die Schaffung eines oder mehrerer Meßsignalzugänge zu einer Hohlleiteranordnung ermöglicht, ohne dieselbe vollständig demontieren zu müssen.

Erfindungsgemäß wird diese Aufgabe durch die Merkmale des Anspruchs 1 gelöst. Vorteilhafte Anordnungen gehen aus den anderen Ansprüchen hervor.

Nach dem Verfahren der Erfindung braucht man, um einen Meßsignalzugang zu schaffen, nur einen leicht zugänglichen Deckel an einer Hohlleiterseitenwand zu entfernen und diesen durch eine Koppelvorrichtung zu ersetzen. Nach vollendetem Meßvorgang wird die Koppelvorrichtung abgenommen und die Öffnung in der Hohlleiterseitenwand wieder mit dem Deckel verschlossen. Die Koppelvorrichtung ist also wiederverwendbar und kann für alle anfallenden Messungen eingesetzt werden, was sich als besonders vorteilhaft erweist, wenn eine Hohlleiteranordnung in großen Stückzahlen hergestellt wird.

Anhand mehrerer in der Zeichnung dargestellter Ausführungsbeispiele wird nachfolgend die Erfindung näher erläutert. Es zeigen:
- Figur 1: eine Draufsicht auf eine Hohlleiteranordnung mit einem Hohlleiterkrümmer als Meßsignalzugang,
- Figur 2: einen Längsschnitt A-A durch den Hohlleiterkrümmer,
- Figur 3: eine Draufsicht auf eine Hohlleiteranordnung mit einem Umlenkformtei als Meßsignalzugang,
- Figur 4: einen Längsschnitt B-B durch das Umlenkformteil,
- Figur 5: eine Draufsicht auf eine Hohlleiteranordnung mit einem Richtkoppler als Meßsignalzugang und
- Figur 6: einen Längsschnitt C-C durch den Richtkoppler.

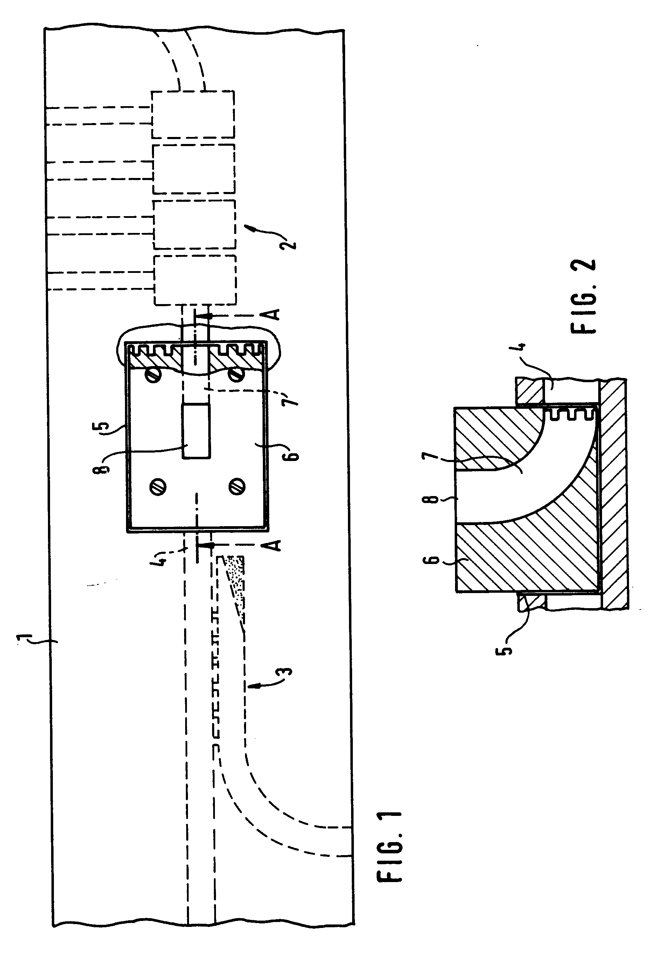

Der Figur 1 ist eine Draufsicht auf einen Ausschnitt einer Hohlleiteranordnung 1 zu entnehmen, die beispielsweise ein mehrkreisiges Filter 2 und einen Richtkoppler 3 besitzt. Z.B. zwischen dem Filter 2 und dem Richtkoppler 3 soll eine Meßstelle vorgesehen werden. Zu diesem Zweck ist in die zugängliche obere Seitenwand des sich zwischen dem Filter 2 und dem Richtkoppler 3 erstreckenden Hohlleiters 4 eine Öffnung 5 eingefräßt, die normalerweise durch einen abnehmbaren Deckel verschlossen ist.

Soll nun eine Messung an dieser Stelle vorgenommen werden, so wird dieser Deckel entfernt und an seiner Stelle wird eine Koppelvorrichtung in die Öffnung 5 eingesetzt. Die Koppelvorrichtung dient dazu, entweder ein Meßsignal in den Hohlleiter 4 einzukoppeln, um es an einer anderen Stelle der Hohlleiteranordnung zur Messung wieder auszukoppeln oder ein irgendwoanders eingekoppeltes Meßsignal zu Meßzwecken auszukoppeln. Drei mögliche Ausführungsformen für eine solche Koppelvorrichtung sollen nun beschrieben werden.

Das in der Fig. 1 als Draufsicht und in der Fig. 2 im Längsschnitt A-A dargestellte Koppelelement ist ein Umlenkelement 6 in Form eines in der H-Ebene (bzw. E-Ebene) gekrümmten Hohlleiterstücks 7, das kontaktlos in den Hohlleiter 4 eindringt. Über dieses gekrümmte Hohlleiterstück 7 werden entweder Meßsignale einer bestimmten Ausbreitungsrichtung aus dem Hohlleiter 4 zu einem Ein- bzw. Ausgangstor 8 des Umlenkelementes 6 herausgeführt oder Meßsignale, die in das Ein- bzw. Ausgangstor 8 eingespeist werden, in den Hohlleiter 4 hineingeführt. Die Richtung, in die Meßsignale eingekoppelt bzw. aus der Meßsignale ausgekoppelt werden, hängt von der Krümmungsrichtung des Hohlleiterstücks 7 ab. Eine Richtungsumkehr kann durch einfaches Umdrehen des Umlenkelementes 6 vorgenommen werden. Eine an der Stirnseite des in den Hohlleiter 4 hineinragenden Endes des gekrümmten Hohlleiterstücks 7 eingelassene Sperrstruktur (Waffeleisenstruktur) verhindert eine Wellenausbreitung durch den Spalt zwischen dem Umlenkelement 6 und dem Hohlleiter 4.

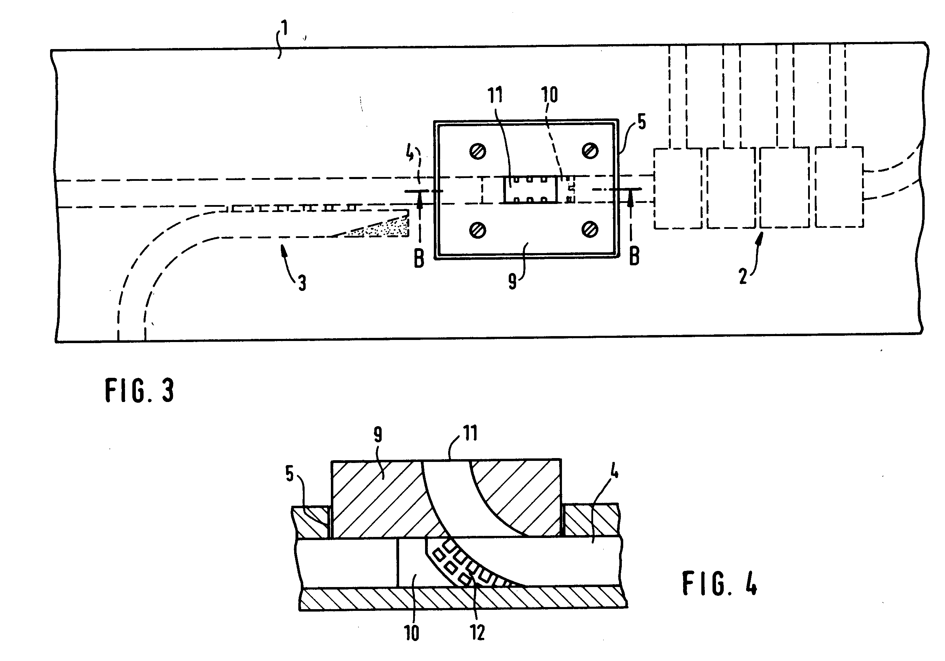

Ein anderes Umlenkelement 9 geht aus der Fig. 3 (Draufsicht) und der Fig. 4 (Längsschnitt B-B) hervor. Es unterscheidet sich von dem soeben beschriebenen Umlenkelement 6 dadurch, daß anstelle eines gekrümmten Hohlleiterstücks lediglich ein gekrümmtes Formtei 10 kontaktfrei in den Hohlleiter 4 hineinragt. Über die gebogene Oberseite des Formteils 10 werden Meßsignale aus dem Hohlleiter 4 zum Ein- bzw. Ausgangstor 11 dieses Umlenkelementes 9 herausgeführt oder Meßsignale vom Ein- bzw. Ausgangstor 11 her in ihn hineingeführt. Auch hier kann durch Umdrehen des Umlenkelements 9 die Ein- bzw. Auskoppelrichtung umgekehrt werden. In diejenigen Seitenwände des Formteils 10, welche mit den Innenwänden des Hohlleiters 4 unmittelbar benachbart sind, ist eine Wellensperrstruktur 12, z.B. in Gestalt einer Waffeleisenstruktur, eingefräst. Diese Wellensperrstruktur 12 verhindert, daß sich Wellen in den Spalten zwischen dem Formteil 10 und den Hohlleiterinnenwänden ausbreiten.

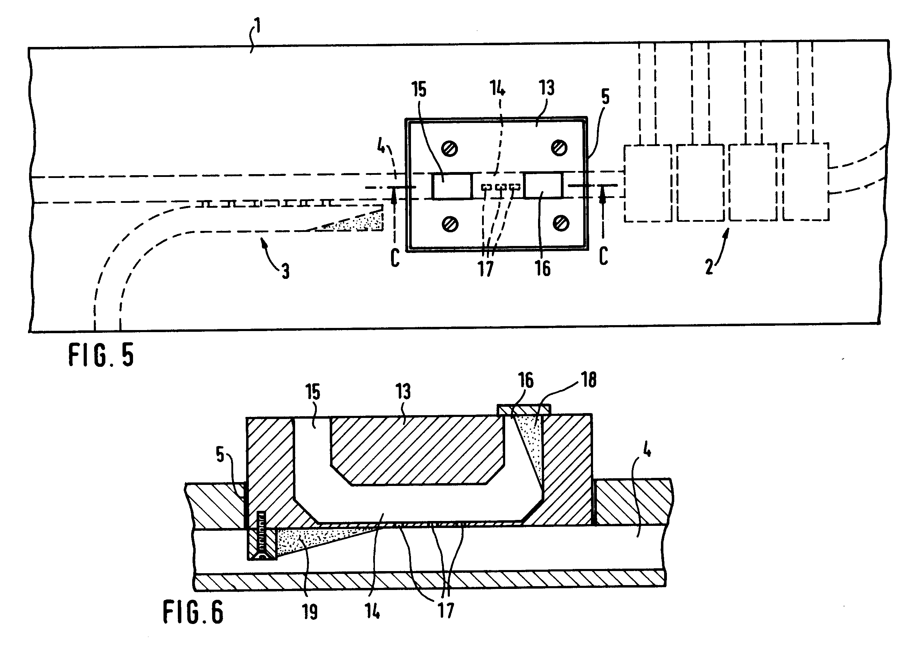

Das in der Fig. 5 (Draufsicht) und der Fig. 6 (Längsschnitt C-C) dargestellte Koppelelement 13 hat die Eigenschaften eines Richtkopplers. Und zwar weist das in die Öffnung 5 des Hohlleiters 4 eingesetzte Koppelelement 13 einen Hohlleiterabschnitt 14 mit zwei Ein- bzw. Ausgangstoren 15 und 16 auf, der über eine gewisse Länge parallel zum Hohlleiter 4 verläuft und dessen ihn vom Hohlleiter 4 trennende Wand mit Koppelöffnungen 17 versehen ist. Die Länge, über die der Hohlleiterabschnitt 14 parallel zum Hohlleiter 4 verläuft, und die Orte der Koppelöffnungen 17 sind so gewählt, daß der Hohlleiterabschnitt 14 zusammen mit dem Hohlleiter 4 einen Richtkoppler bildet. Ein solcher Richtkoppler erlaubt es, in oder aus jeder Richtung des Hohlleiters 4 Meßsignale ein- oder auszukoppeln. Wenn erforderlich, kann jeweils dasjenige Ein- bzw. Ausgangstor 15 bzw. 16, das nicht für die Ein- bzw. Auskopplung von Meßsignalen vorgesehen ist, mit einem Absorber 18 abgeschlossen werden.

Die Ausbreitung von Meßsignalen in eine nicht gewünschte Richtung im Hohlleiter 4 kann dadurch verhindert werden, daß an der Unterseite des Koppelelements 13 ein in den Hohlleiter 4 hineinragender Absorber 19 angebracht wird. Bei komplexen integrierten Hohlleiterschaltungen mit einer Vielzahl von Meßstellen wäre es sehr zeitaufwendig, wenn die Meßsignalzugänge einzeln nacheinander eingerichtet würden. Sehr viel weniger zeitaufwendig ist es, den bei integrierten Hohlleiterschaltungen üblicherweise vorhandenen Deckel, der mindestens eine Seitenwand der zu der integrierten Schaltung gehörenden Hohlleiter bildet, für den Meßvorgang durch einen anderen Deckel zu ersetzen, der sich von dem eigentlichen Deckel nur dadurch unterscheidet, daß in ihm an den vorgesehenen Meßstellen Koppelelemente der oben beschriebenen Art installiert sind. Dieser eine mit Koppelelementen bestückte Deckel kann für die Messung einer jeden zu ihm passenden integrierten Hohlleiterschaltung verwendet werden.

## Patentansprüche

1. Anordnung zur Schaffung mindestens eines Meßsignalzugangs zu einer aus mindestens einem Hohlleiter bestehenden Hohlleiteranordnung, um in diese Meßsignale einkoppeln und/oder daraus auskoppeln zu können, gekennzeichnet durch einen ersten Deckel, der eine Öffnung (5) an einer als Meßsignalzugang geeigneten Stelle in einer Hohlleiterwand abdeckt, und durch einen zweiten Deckel ersetzbar ist, der an jeder als Meßsignalzugang vorgesehenen Stelle der Hohlleiteranordnung eine Koppelvorrichtung (6, 9, 13) aufweist.

2. Anordnung nach Anspruch 1, dadurch gekennzeichnet, daß die Koppelvorrichtung (6, 4) ein Eingangs- bzw. Ausgangstor (8, 11) besitzt, an das sich ein in das Hohlleiterinnere kontaktfrei hineinragendes Umlenkelement (7, 10) anschließt, über das entweder Meßsignale einer bestimmten Ausbreitungsrichtung aus dem Hohlleiter (4) zum Ein- bzw. Ausgangstor (8, 11) herausgeführt oder Meßsignale, die zu Meßzwecken in das Eingangs- bzw. Ausgangstor (8, 11) eingespeist werden, in den Hohlleiter (4) hineingeführt werden.

3. Anordnung nach Anspruch 2, dadurch gekennzeichnet, daß das Umlenkelement ein in der E- oder H-Ebene gekrümmtes Hohlleiterstück (7) ist.

4. Anordnung nach Anspruch 2, dadurch gekennzeichnet, daß das Umlenkelement ein gekrümmtes Formteil (10) ist, dessen Oberfläche zumindest teilweise mit einer Wellensperrstruktur (12) versehen ist, die eine Wellenausbreitung im Spalt zwischen dem Formteil (10) und den Hohlleiterinnenwänden verhindert.

5. Anordnung nach Anspruch 4, dadurch gekennzeichnet, daß die in die Oberfläche des Formteils (10) eingelassene Wellensperrstruktur (12) eine Waffeleisenstruktur ist.

6. Anordnung nach Anspruch 1, dadurch gekennzeichnet, daß die Koppelvorrichtung (13) einen Hohlleiterabschnitt (14) aufweist, der auf einer solchen Länge parallel zu dem einen Meßvorgang zu unterziehenden Hohlleiter (4) verläuft und dessen dem Hohlleiterinneren zugewandte Seitenwand derart mit Koppelöffnungen (17) versehen ist, daß der Hohlleiterabschnitt (14) zusammen mit dem Hohlleiter (4) einen Richtkoppler bildet.

## Claims

1. An arrangement for creating at least one measuring signal access to a waveguide arrangement composed of at least one waveguide in order to be able to couple measuring signals into it or out of it, characterised by a first cover that covers an opening (5) in a waveguide wall at a location suitable as measuring signal access and can be replaced by a second cover which is provided with a coupling device (6, 9, 13) at every location intended for the measuring signal access.

2. An arrangement according to claim 1, characterised in that the coupling device (6, 4) includes an input/output port (8, 11) which is followed by a deflection element (7, 10) that projects into the interior of the waveguide without making contact and through which measuring signals of a certain propagation direction are brought out of the waveguide (4) to the input/output port (8, 11) or measuring signals fed into the input/output port (8, 11) for measurement purposes are brought into the waveguide (4).

3. An arrangement according to claim 2, characterised in that the deflection element is a waveguide section (7) which is curved in the E-plane or in the H-plane.

4. An arrangement according to claim 2, characterised in that the deflection element is a curved molded member (10) whose surface is at least in part provided with a wave blocking structure (12) which prevents the propagation of waves in the gap between the molded member (10) and the interior walls of the waveguide.

5. An arrangement according to claim 4, characterised in that the wave blocking structure (12) inserted into the surface of the molded member (10) is a waffle-iron structure.

6. An arrangement according to claim 1, characterised in that the coupling device (13) includes a waveguide section (14) which extends parallel to the waveguide (4) that is to be subjected to the measuring process over such a length and whose side wall facing the waveguide interior is provided with coupling openings (17) in such a manner that the waveguide section (14) together with the waveguide (4) form a directional coupler.

## Revendications

1. Agencement pour réaliser au moins un accès pour des signaux de mesure vers un ensemble de guides d'ondes qui comprend au moins un guide d'onde, afin de pouvoir injecter des signaux de mesure dans cet ensemble de guides d'ondes et/ou d'en extraire des signaux de mesure, caractérisé par un premier couvercle, qui couvre une ouverture (5) à un emplacement approprié en tant qu'accès pour des signaux de mesure dans une paroi du guide d'onde, et qui peut être remplacé par un second couvercle, lequel comporte un dispositif d'accouplement (6, 9, 13) à chaque emplacement de l'ensemble de guides d'ondes prévu comme accès pour les signaux de mesure.

2. Agencement selon la revendication 1, caractérisé en ce que le dispositif d'accouplement (6, 4) comprend une porte d'entrée/sortie (8, 11) à laquelle est raccordé un élément déflecteur (7, 10) qui pénètre sans contact dans l'intérieur du guide d'onde, au moyen duquel on mène des signaux de mesure ayant une direction de propagation donnée hors du guide d'onde (4) vers la porte d'entrée/sortie (8, 11), ou on introduit dans le guide d'onde (4) des signaux de mesure qui sont alimentés à des fins de mesure dans la porte d'entrée/sortie (8, 11).

3. Agencement selon la revendication 2, caractérisé en ce que l'élément déflecteur est une pièce de guide d'onde (7) courbée dans le plan E ou dans le plan H.

4. Agencement selon la revendication 2, caractérisé en ce que l'élément déflecteur est une pièce en forme coudée (10) dont la surface est munie au moins partiellement d'une structure de blocage d'ondes (12) qui empêche une propagation des ondes dans la lente entre la pièce en forme (10) et les parois intérieures du guide d'onde.

5. Agencement selon la revendication 4, caractérisé en ce que la structure de blocage des ondes (12) encastrée dans la surface de la pièce en forme (10) est une structure métallique gaufrée.

6. Agencement selon la revendication 1, caractérisé en ce que le dispositif d'accouplement (13) comprend un tronçon de guide d'onde (14) qui s'étend parallèlement au guide d'onde (4) à soumettre à une opération de mesure sur une longueur telle et dont la paroi latérale dirigée vers l'intérieur du guide d'onde est pourvue d'ouvertures de couplage (17) de manière telle que le tronçon de guide d'onde (14) forme ensemble avec le guide d'onde (4) un coupleur directionnel.
